# EUROPEAN PATENT APPLICATION

(11) **EP 4 557 911 A1**
(43) Date of publication of application: **21.05.2025**
(21) Application number: 24191220.3
(22) Date of filing: 26.07.2024
(51) Int. Cl.: H10D 84/01, H10D 62/10, H10D 84/03, H10D 88/00

(54) **SEMICONDUCTOR DEVICE**

(30) Priority: 20.11.2023 KR 20230161457
(71) Applicant: Samsung Electronics Co., Ltd, Suwon-si, Gyeonggi-do 16677 (KR)
(72) Inventor: HWANG, Kyuman, 16677 Suwon-si (KR); BAE, Jinho, 16677 Suwon-si (KR); JEONG, Jaewon, 16677 Suwon-si (KR); PARK, Sungil, 16677 Suwon-si (KR)
(74) Representative: Marks & Clerk LLP

(57) **Abstract**

A semiconductor device includes a lower transistor and an upper transistor located at a higher vertical level than the lower transistor. The lower transistor includes a lower source/drain region, and a lower gate structure and a lower isolation insulating layer that are in contact with a side surface of the lower source/drain region. The upper transistor includes an upper source/drain region, and an upper gate structure and an upper isolation insulating layer that are in contact with a side surface of the upper source/drain region. A bottom surface of the lower isolation insulating layer is located at a same vertical level as a bottom surface of the lower gate structure.

## Description

### TECHNICAL FIELD

Embodiments of the inventive concept are directed to a semiconductor device, and more particularly, to a semiconductor device that includes a three-dimensional stacked (3DS) field effect transistor (FET).

### DISCUSSION OF THE RELATED ART

Down-scaling of semiconductor devices has been rapidly progressing. In addition, because semiconductor devices should have fast operating speeds and accuracy in operation, the structure of transistors in a semiconductor device is being optimized. In particular, as semiconductor devices become highly integrated, semiconductor devices include three-dimensional transistors with a multi-gate structure.

### SUMMARY

Embodiments of the inventive concept provide a semiconductor device with improved structural reliability.

According to an embodiment of the inventive concept, there is provided a semiconductor device that includes a lower transistor and an upper transistor located at a higher vertical level than the lower transistor. The lower transistor includes a lower source/drain region, and a lower gate structure and a lower isolation insulating layer that are in contact with a side surface of the lower source/drain region. The upper transistor includes an upper source/drain region, and an upper gate structure and an upper isolation insulating layer that are in contact with a side surface of the upper source/drain region. A bottom surface of the lower isolation insulating layer is positioned at the same vertical level as a bottom surface of the lower gate structure.

According to another embodiment of the inventive concept, there is provided a semiconductor device that includes a lower transistor and an upper transistor located at a higher vertical level than the lower transistor. The lower transistor includes a lower source/drain region, a lower gate structure and a lower isolation insulating layer that are in contact with a side surface of the lower source/drain region, where a lower gate and a lower nanosheet are alternately stacked on the lower gate structure and the lower isolation insulating layer, and a lower source/drain contact in contact with the lower source/drain region. The upper transistor includes an upper source/drain region, an upper gate structure and an upper isolation insulating layer that are in contact with a side surface of the upper source/drain region, where an upper gate and an upper nanosheet are alternately stacked on the upper gate structure and the upper isolation insulating layer, and an upper source/drain contact in contact with the upper source/drain region. A bottom surface of the lower isolation insulating layer is located at the same vertical level as a bottom surface of the lower gate structure.

According to an embodiment of the inventive concept, there is provided a semiconductor device that includes a lower transistor and an upper transistor located at a higher vertical level than the lower transistor. The lower transistor includes a lower source/drain region, and a lower gate, a lower nanosheet, and a lower isolation insulating layer that are in contact with a side surface of the lower source/drain region. The upper transistor includes an upper source/drain region, an upper gate, an upper nanosheet, and an upper isolation insulating layer that are in contact with a side surface of the upper source/drain region, and an upper horizontal insulating layer disposed on the upper gate and at an uppermost end and that extends in one horizontal direction. The lower gate and the lower nanosheet are alternately stacked, the upper gate and the upper nanosheet are alternately stacked, each of the lower gate and the lower nanosheet is spaced apart from the lower isolation insulating layer in a horizontal direction, each of the upper gate and the upper nanosheet is spaced apart from the upper isolation insulating layer in the horizontal direction, and a bottom surface of the lower isolation insulating layer is located at the same vertical level as a bottom surface of the lower gate at a lowermost end.

At least some of the above and other features of the invention are set out in the claims.

### BRIEF DESCRIPTION OF THE DRAWINGS

FIG. 1 is a planar layout diagram of a semiconductor device according to an embodiment.
FIG. 2 is a cross-sectional view taken along a line I-I' of FIG. 1, according to an embodiment.
FIG. 3 is an enlarged cross-sectional view of a region A of FIG. 2, according to an embodiment.
FIG. 4 is an enlarged cross-sectional view of the region A of FIG. 2, according to an embodiment.
FIG. 5 is a cross-sectional view taken along the line I-I' of FIG. 1, according to an embodiment.
FIGS. 6 to 17 are cross-sectional views illustrating a method of manufacturing a semiconductor device, according to an embodiment.
FIG. 18 is a circuit diagram of a semiconductor device according to an embodiment.

### DETAILED DESCRIPTION

Reference will now be made in detail to embodiments, examples of which are illustrated in the accompanying drawings, wherein like reference numerals may refer to like elements throughout. In this regard, the present embodiments may have different forms and should not be construed as being limited to the descriptions set forth herein.

Hereinafter, embodiments of the inventive concept will be described in detail with reference to the accompanying drawings. The same reference numerals may be used for the same components in the drawings, and redundant descriptions thereof may be omitted.

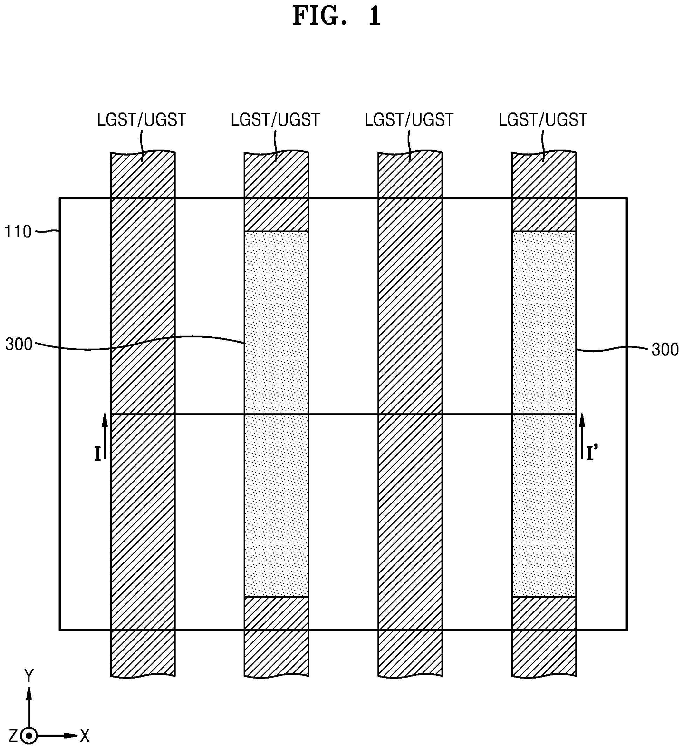

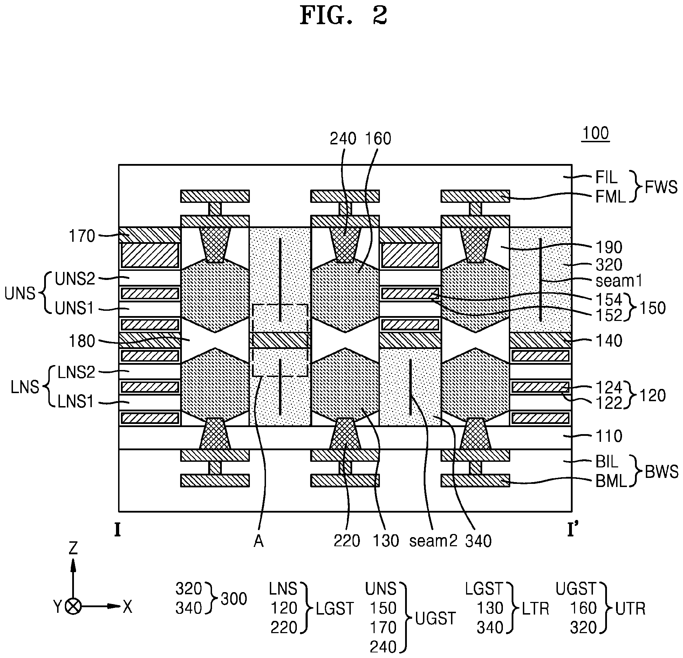

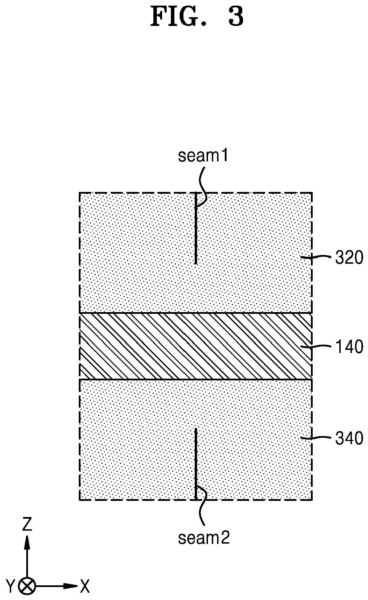

FIG. 1 is a planar layout diagram of a semiconductor device according to an embodiment. FIG. 2 is a cross-sectional view taken along a line I-I' of FIG. 1, according to an embodiment. FIG. 3 is an enlarged cross-sectional view of a region A of FIG. 2, according to an embodiment.

Referring to FIGS. 1 to 3, in an embodiment, a semiconductor device 100 includes a first insulating layer 110, a second insulating layer 180, a third insulating layer 190, an isolation insulating layer structure 300, a lower transistor LTR, and an upper transistor UTR.

The semiconductor device 100 of an embodiment of the inventive concept includes field effect transistors (FETs). For example, the semiconductor device 100 includes a complementary metal-oxide-semiconductor field effect transistor (cFET). The complementary metal-oxide-semiconductor field effect transistor includes a metal-oxide-semiconductor (MOS) transistor. For example, the complementary metal oxide semiconductor field effect transistors includes N-channel metal-oxide-semiconductor (NMOS) transistors and P-channel metal-oxide-semiconductor (PMOS) transistors.

In this specification, horizontal directions (X direction and/or Y direction) refer to directions parallel to a main surface (e.g. an upper or lower surface) of the first insulating layer 110, and a vertical direction (Z direction) refers to a direction perpendicular to the horizontal directions (X direction and/or Y direction). A first horizontal direction (e.g. X direction) may be defined that intersects a second horizontal direction (e.g. Y direction). The first and second horizontal directions may be perpendicular to each other.

In addition, the semiconductor device 100 has two surfaces spaced apart from each other in the vertical direction, in which one surface that is closer to a back wiring structure (BWS) may be referred to as a bottom surface, and the other surface opposite to the bottom surface may be referred to as a top surface. It will be appreciated that the terms "horizontal" and "vertical" and similar terms (e.g. "upper", "lower", "top", "bottom", etc.) are relative to the structure of the semiconductor device, and need not imply any particular orientation of the semiconductor device in use. For instance, an upper feature may be a feature that is located further along the vertical direction than a lower feature.

The first insulating layer 110 includes at least one of silicon nitride (SiN), silicon oxide (SiO), SiCN, SiBN, SiON, SiOCN, SiBCN, SiOC, and a combination thereof. The lower transistor LTR and the upper transistor UTR are arranged on the first insulating layer 110.

The lower transistor LTR and the upper transistor UTR are located at different vertical levels. For example, the upper transistor UTR is located at a higher vertical level than the lower transistor LTR.

The semiconductor device further includes a front wiring structure FWS disposed at a higher vertical level than a plurality of upper transistors UTR and a back wiring structure BWS disposed at a lower vertical level than a plurality of lower transistors LTR. Various vertical levels may represent relative positions along the vertical direction. In embodiments, the front wiring structure FWS transmits signal voltages to the plurality of lower transistors LTR and the plurality of upper transistors UTR, and the back wiring structure BWS transmits power voltages and a ground voltage to the plurality of lower transistors LTR and the plurality of upper transistors UTR.

The lower transistor LTR includes a lower gate structure LGST, a lower source/drain region 130, and a lower isolation insulating layer 340. The lower gate structure LGST includes a lower gate 120 and a lower nanosheet structure LNS that are alternately stacked in a vertical direction (Z direction) on the first insulating layer 110. In addition, the lower gate structure LGST further includes a lower source/drain contact 220 in contact with the lower source/drain region 130.

In addition, the upper transistor UTR includes an upper gate structure UGST, an upper source/drain region 160, and an upper isolation insulating layer 320. The upper gate structure UGST includes an upper gate 150 and an upper nanosheet structure UNS that are alternately stacked in the vertical direction (Z direction) on the lower gate structure LGST. In addition, the upper gate structure UGST further includes an upper source/drain contact 240 in contact with the upper source/drain region 160 and an upper horizontal insulating layer 170.

In embodiments, the plurality of lower transistors LTR are PMOS transistors and the plurality of upper transistors UTR are NMOS transistors. In other embodiments, the plurality of lower transistors LTR are NMOS transistors and the plurality of upper transistors UTR are PMOS transistors. In other embodiments, the plurality of lower transistors LTR are NMOS transistors that each have a first threshold voltage, and the plurality of upper transistors UTR are NMOS transistors that each have a second threshold voltage that differs from the first threshold voltage. In other embodiments, the plurality of lower transistors LTR are PMOS transistors that each have a first threshold voltage, and the plurality of upper transistors UTR are PMOS transistors that each have a second threshold voltage different from the first threshold voltage.

Each of the lower nanosheet structure LNS and the upper nanosheet structure UNS extends in the second horizontal direction (Y direction). Each of the lower nanosheet structure LNS and the upper nanosheet structure UNS includes two nanosheets spaced apart in the vertical direction (Z direction). The lower nanosheet structure LNS includes a first lower nanosheet LNS 1 and a second lower nanosheet LNS2. In addition, the upper nanosheet structure UNS includes a first upper nanosheet UNS 1 and a second upper nanosheet UNS2. The number of nanosheets in each of the lower nanosheet structure LNS and/or the upper nanosheet structure UNS is not necessarily limited to those shown, and may be variously modified in other embodiments. That is, various embodiments may include one or more nanosheets in each of the upper nanosheet structure UNS and the lower nanosheet structure LNS. The term "nanosheet" may refer to a layer having a thickness falling in the range of 1-100 nm.

Each of the first lower nanosheet LNS 1 and the second lower nanosheet LNS2 in the lower nanosheet structure LNS, and the first upper nanosheet UNS1 and the second upper nanosheet UNS2 in the upper nanosheet structure UNS functions as a channel region. In embodiments, the first lower nanosheet LNS1, the second lower nanosheet LNS2, the first upper nanosheet UNS1, and the second upper nanosheet UNS2 each have substantially the same thickness in the vertical direction (Z direction). In other embodiments, at least some of the first lower nanosheet LNS1, the second lower nanosheet LNS2, the first upper nanosheet UNS1, and the second upper nanosheet UNS2 have a different thickness in the vertical direction (Z direction).

As illustrated in FIG. 2, the first lower nanosheet LNS 1, the second lower nanosheet LNS2, the first upper nanosheet UNS1, and the second upper nanosheet UNS2 each have the same or similar sizes in the first horizontal direction (X direction). In other embodiments, at least some of the first lower nanosheet LNS1, the second lower nanosheet LNS2, the first upper nanosheet UNS1, and the second upper nanosheet UNS2 have a different size in the first horizontal direction (X direction).

Each of the lower nanosheet structure LNS and the upper nanosheet structure UNS includes at least one of a group IV semiconductor such as Si or Ge, a group IV-IV compound semiconductor such as SiGe or SiC, and a group III-V compound semiconductor such as GaAs, InAs, or InP.

Each of the lower gate 120 and the upper gate 150 surrounds the respective nanosheet structure and extends in the second horizontal direction (Y direction). For instance, the lower gate 120 includes a series of layers stacked above and below each of the first and second lower nanosheets LNS1 and LNS2 such that the lower gate 120 and the lower nanosheet structure LNS are alternately stacked in the vertical direction. Similarly, the upper gate 150 includes a series of layers stacked above and below each of the first and second upper nanosheets UNS1 and UNS2 such that the upper gate 150 and the upper nanosheet structure UNS are alternately stacked in the vertical direction. Each of the lower gate 120 and the upper gate 150 are stacked and spaced apart from each other in the vertical direction (Z direction).

The lower gate 120 includes a lower gate dielectric layer 122 and a lower gate electrode 124, and the upper gate 150 includes an upper gate dielectric layer 152 and an upper gate electrode 154. The lower gate dielectric layer 122 surrounds the lower gate electrode 124, and the upper gate dielectric layer 152 surrounds the upper gate electrode 154.

Each of the lower gate dielectric layer 122 and the upper gate dielectric layer 152 includes at least one of a silicon oxide layer, a silicon oxynitride layer, a high-k dielectric layer that has a dielectric constant higher than that of a silicon oxide layer, and a combination thereof. The high dielectric layer includes at least one of a metal oxide and a metal oxynitride. For example, a high-k dielectric layer that is usable as the lower gate dielectric layer 122 and the upper gate dielectric layer 152 includes at least one of HfO₂, HfSiO, HfSiON, HfTaO, HfTiO, HfZrO, ZrO₂, Al₂O₃, and a combination thereof, but is not necessarily limited thereto.

Each of the lower gate electrode 124 and the upper gate electrode 154 includes at least one of doped polysilicon, a metal, a conductive metal nitride, a conductive metal carbide, a conductive metal silicide, and a combination thereof, and includes, for example, at least one of Ag, Al, Cu, Ti, Ta, W, Mo, TaN, NiSi, CoSi, TiN, WN, TiAl, TiAlN, TaCN, TaC, TaSiN, and a combination thereof, but is not necessarily limited thereto. In embodiments, each of the lower gate electrode 124 and the upper gate electrode 154 includes a work function metal-containing layer and a gap-fill metal layer. The work function metal-containing layer includes at least one of Ti, W, Ru, Nb, Mo, Hf, Ni, Co, Pt, Yb, Tb, Dy, Er, and Pd. The gap-fill metal layer includes one of a W layer and an Al layer. In embodiments, each of the lower gate electrode 124 and the upper gate electrode 154 includes one of a stacked structure of silver TiAlC/TiN/W, a stacked structure of TiN/TaN/TiAlC/TiN/W, and a stacked structure of TiN/TaN/TiN/TiAlC/TiN/W, but is not necessarily limited thereto.

A lower horizontal insulating layer 140 is disposed between the lower gate structure LGST and the upper gate structure UGST, between the lower gate structure LGST and the upper isolation insulating layer 320, between the lower isolation insulating layer 340 and the upper gate structure UGST, and between the lower isolation insulating layer 340 and the upper isolation insulating layer 320, respectively. In addition, an upper horizontal insulating layer 170 is disposed in an upper region of the upper gate structure UGST. The lower horizontal insulating layers 140 protect and electrically isolate the lower gate structure LGST and the upper gate structure UGST from each other, and the upper horizontal insulating layers 170 is disposed on an uppermost end of the upper gate electrode 154 and electrically isolates the uppermost end of the upper gate electrode 154 from other components of the semiconductor device 100. The lower horizontal insulating layers 140 and the upper horizontal insulating layers 170 each include at least one of silicon nitride (SiN), silicon oxide (SiO), SiCN, SiBN, SiON, SiOCN, SiBCN, SiOC, and a combination thereof.

The upper isolation insulating layer 320 and the lower isolation insulating layer 340 extend in the second horizontal direction (Y direction) and the vertical direction (Z direction). The upper isolation insulating layer 320 extends from a vertical level of a top surface of the upper gate structure UGST to a vertical level of a bottom surface of the upper gate structure UGST, and the lower isolation insulating layer 340 extends from a vertical level of a top surface of the lower gate structure LGST to a vertical level of a bottom surface of the lower gate structure LGST. A top surface of the upper isolation insulating layer 320 may be located at a same vertical level to a top surface of the upper gate structure UGST and a bottom surface of the upper isolation insulating layer 320 may be located at a same vertical level to a bottom surface of the upper gate structure UGST. A top surface of the lower isolation insulating layer 340 may be located at a same vertical level to a top surface of the lower gate structure LGST and a bottom surface of the lower isolation insulating layer 340 may be located at a same vertical level to a bottom surface of the lower gate structure LGST. The upper isolation insulating layer 320 may be spaced apart from the upper gate structure UGST in the first horizontal direction. The lower isolation insulating layer 340 may be spaced apart from the lower gate structure LGST in the first horizontal direction.

The upper isolation insulating layer 320 includes a first seam seam1 therein, and the lower isolation insulating layer 340 includes a second seam seam2 therein. The first and second seams seam1 and seam2 are empty spaces generated during the formation of the isolation insulating layer structure 300. The term "empty" in this context may refer to a region that is not filled with solid insulating material. An empty space may therefore include a gas (such as atmospheric gas present during the formation of the isolation insulating layers).

When viewed in a plan view, the first seam seam1 is located in a central portion of the upper isolation insulating layer 320 in the first horizontal direction (X direction), and the second seam seam2 is located in a central portion of the lower isolation insulating layer 340 in the first horizontal direction (X direction). In addition, each of the first seam seam1 and the second seam seam2 is spaced apart from the lower horizontal insulating layer 140 in the vertical direction (Z direction).

In a cross-section in which the upper isolation insulating layer 320 and the lower isolation insulating layer 340 are in contact with the lower horizontal insulating layer 140, each of the upper isolation insulating layer 320 and the lower isolation insulating layer 340 has a rectangular shape. For example, the bottom surface of the upper isolation insulating layer 320 and the top surface of the lower isolation insulating layer 340 each have a flat shape. However, the shapes of the lower horizontal insulating layer 140, the upper isolation insulating layer 320, and the lower isolation insulating layer 340 may be modified in various ways. For example, in a process of forming the upper isolation insulating layer 320 and the lower isolation insulating layer 340, the shapes of the lower horizontal insulating layer 140, the upper isolation insulating layer 320, and the lower isolation insulating layer 340 can change according to a change in an etch profile.

Each of the upper isolation insulating layer 320 and the lower isolation insulating layer 340 includes at least one of silicon nitride (SiN), silicon oxide (SiO), SiCN, SiBN, SiON, SiOCN, SiBCN, SiOC, and a combination thereof. For example, the upper isolation insulating layer 320 and the lower isolation insulating layer 340 may each include the same material. In another embodiment, the upper isolation insulating layer 320 and the lower isolation insulating layer 340 include different materials.

The bottom surfaces of each of the lower gate structure LGST and the lower isolation insulating layer 340 are located at the same vertical level, and the top surface of each of the upper gate structure UGST and the upper isolation insulating layer 320 are located at the same vertical level. In other embodiments, the bottom surface of each of the lower gate structure LGST and the lower isolation insulating layer 340 are located at the same vertical level, and the top surface of each of the upper gate structure UGST and the upper isolation insulating layer 320 are located at different vertical levels. The term "vertical level" used in the present specification refers to a distance from the back wiring structure (BWS) in the vertical direction (Z direction or -Z direction).

Since the semiconductor device 100 includes the upper isolation insulating layer 320 and the lower isolation insulating layer 340, diversity in layouts of the lower transistor LTR and the upper transistor UTR can increase.

In addition, each of the lower gate structure LGST, the upper gate structure UGST, the upper isolation insulating layer 320, and the lower isolation insulating layer 340 further includes a spacer that extends in a second horizontal direction (Y direction) and a vertical direction (Z direction) on each sidewall. The spacer electrically isolates each of the lower gate structure LGST, the upper gate structure UGST, the upper isolation insulating layer 320, and the lower isolation insulating layer 340 from source/drain regions.

Each of the lower source/drain regions 130 is disposed between the plurality of lower gate structures LGST, between the lower gate structure LGST and the lower isolation insulating layer 340, and between the plurality of lower isolation insulating layers 340. Each of the lower source/drain regions 130 is either located between one of the lower gate structures LGST and one of the lower isolation insulating layers 340, or between two lower isolation insulating layers 340. For instance, for one or more lower source/drain regions 130, a lower gate structure LGST is in contact with a first sidewall of the lower source/drain region 130 and a lower isolation insulating layer 340 is in contact with an opposite sidewall of the lower source/drain region 130. Similarly, for one or more other lower source/drain regions 130, lower isolation insulating layers 340 are in contact with opposite sidewalls of the other lower source/drain region 130. In addition, each of the upper source/drain region 160 is interposed between the plurality of the upper gate structures UGST, between the upper gate structure UGST and the upper isolation insulating layers 320, and between the plurality of the upper isolation insulating layers 320. Each of the upper source/drain regions 160 is either located between one of the upper gate structures UGST and one of the upper isolation insulating layers 320, or between two upper isolation insulating layers 320. For instance, for one or more upper source/drain regions 160, an upper gate structure UGST is in contact with a first sidewall of the upper source/drain region 160 and an upper isolation insulating layer 320 is in contact with an opposite sidewall of the upper source/drain region 160. Similarly, for one or more other upper source/drain regions 160, upper isolation insulating layers 320 are in contact with opposite sidewalls of the other upper source/drain region 160.

The lower source/drain regions 130 and the upper source/drain regions 160 are located on both sides of a nanosheet structure. The lower source/drain regions 130 and the upper source/drain regions 160 are in contact with the sidewalls of the nanosheet structure that are surrounded by adjacent gates. The lower source/drain regions 130 are in contact with the sidewalls of each of the first lower nanosheet LNS1 and the second lower nanosheet LNS2 of the lower nanosheet structure LNS, and the upper source/drain regions 160 are in contact with the sidewalls of each of the first upper nanosheet UNS1 and the second upper nanosheet UNS2 of the upper nanosheet structure UNS.

The lower source/drain region 130 includes one of an epitaxially-grown Si layer and an epitaxially-grown SiC layer, and the upper source/drain region 160 includes a plurality of epitaxially-grown SiGe layers. For example, each of the lower source/drain regions 130 includes a Si layer doped with an n-type dopant, where the n-type dopant includes phosphorus (P), and each of the upper source/drain region 160 includes an Si₁₋ₓGeₓ layer doped with a p-type dopant (here, x ≠ 0), and the p-type dopant includes at least one of boron (B), gallium (Ga), carbon (C), and a combination thereof, but is not necessarily limited thereto.

In other embodiments, the lower source/drain region 130 includes a plurality of epitaxially-grown SiGe layers, and the upper source/drain region 160 includes one of an epitaxially-grown Si layer and an epitaxially-grown SiC layer. For example, each of the lower source/drain regions 130 includes a Si₁₋ₓGeₓ layer (here, x ≠ 0) layer doped with a p-type dopant, where the p-type dopant incudes at least one of boron (B), gallium (Ga), carbon (C), and a combination thereof, and each of the upper source/drain regions 160 includes a Si layer doped with an n-type dopant, and the n-type dopant includes phosphorus (P), but is not limited thereto.

A second insulating layer 180 is disposed between the lower source/drain region 130 and the upper source/drain region 160, and a third insulating layer 190 is disposed on the upper source/drain region 160. The second insulating layer 180 and the third insulating layer 190 each include at least one of silicon nitride (SiN), silicon oxide (SiO), SiCN, SiBN, SiON, SiOCN, SiBCN, SiOC, and a combination thereof.

The semiconductor device 100 further includes a lower source/drain contact 220 on the lower source/drain region 130 and that extends in the vertical direction (Z direction) toward the first insulating layer 110, and/or an upper source/drain contact 240 on the upper source/drain region 160 and that extends in the vertical direction (Z direction) away from the first insulating layer 110. At least a portion of the lower source/drain contact 220 is surrounded by the lower source/drain region 130, and at least a portion of the upper source/drain contact 240 is surrounded by the upper source/drain region 160. In addition, at least a portion of the lower source/drain contact 220 is surrounded by the second insulating layer 180, and at least a portion of the upper source/drain contact 240 is surrounded by the third insulating layer 190.

In addition, a silicide layer may be further interposed between the lower source/drain region 130 and the lower source/drain contact 220 and/or between the upper source/drain region 160 and the upper source/drain contact 240. For example, the silicide layers include titanium silicide, but is not necessarily limited thereto.

Each of the lower source/drain contact 220 and the upper source/drain contact 240 includes at least one of a metal, a conductive metal nitride, and a combination thereof. For example, each of the lower source/drain contact 220 and the upper source/drain contact 240 includes at least one of W, Cu, Al, Ti, Ta, TiN, TaN, an alloy thereof, and a combination thereof.

A back wiring structure BWS is disposed under the lower source/drain contact 220. The back wiring structure BWS includes a first wiring line BML and a first cover insulating layer BIL. The first wiring line BML includes a plurality of conductive patterns located at different vertical levels and a plurality of conductive vias that connect the plurality of conductive patterns with each other, and the first cover insulating layer BIL includes a plurality of insulating layers that surround the plurality of conductive patterns and the plurality of conductive vias.

A front wiring structure FWS is disposed on the upper source/drain contact 240. The front wiring structure FWS includes a second wiring line FML and a second cover insulating layer FIL. The second wiring line FML includes a plurality of conductive patterns located at different vertical levels and a plurality of conductive vias that connect the plurality of conductive patterns with each other, and the second cover insulating layer FIL includes a plurality of insulating layers that surround the plurality of conductive patterns and the plurality of conductive vias.

In addition, a cover insulating layer and a via may be interposed between the lower source/drain contact 220 and the back wiring structure BWS and/or between the upper source/drain contact 240 and the front wiring structure FWS.

In a general semiconductor device, an isolation insulating layer was formed by performing an etching process at the same vertical level as the top surface of the upper gate structure. Therefore, the arrangement of the transistors of the semiconductor devices may be limited. In addition, when etching was performed from the top surface of the upper gate structure to the bottom surface of the lower gate structure, the isolation insulating layer had a high aspect ratio structure, so the reliability of the isolation insulating layer was low.

However, the semiconductor device 100 according to an embodiment of the inventive concept includes an upper isolation insulating layer 320 formed by performing an etching process at the same vertical level as the top surface of the upper gate structure UGST, and a lower isolation insulating layer 340 formed by performing an etching process at the same vertical level as the bottom surface of the lower gate structure LGST. Therefore, the etch depth of the isolation insulating layer structure 300 decreases, thereby increasing the reliability of the process of forming the isolation insulating layer structure 300. In addition, since the upper isolation insulating layer 320 and the lower isolation insulating layer 340 are formed at different vertical levels, the arrangement of transistors in the semiconductor device 100 can be diversified.

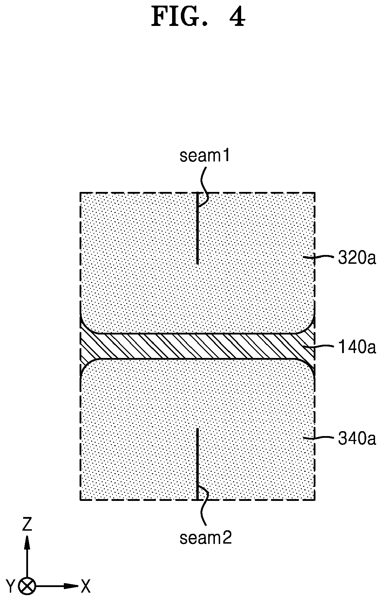

FIG. 4 is an enlarged cross-sectional view of the region A of FIG. 2 according to an embodiment. Description will be made with reference to FIGS. 2 and 4.

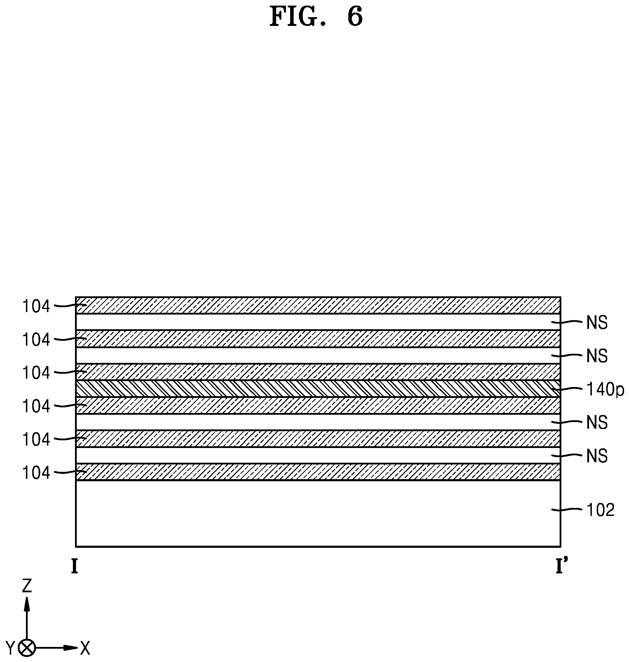

Referring to FIG. 4, in an embodiment, at least some corners where the upper isolation insulating layer 320a and the lower isolation insulating layer 340a face each other are rounded. Since at least some corners where the upper isolation insulating layer 320a and the lower insulating layer 340a face each other are rounded, two surfaces of the lower horizontal insulating layer 140a spaced apart in the vertical direction (Z direction) are rounded. For example, each of the bottom surface of the upper isolation insulating layer 320a and the top surface of the lower isolation insulating layer 340a is rounded. For example, each of the bottom surface of the upper isolation insulating layer 320a and the top surface of the lower isolation insulating layer 340a may be concave (e.g. may have a concave profile). A shape of each of the lower horizontal insulating layer 140a, the upper isolation insulating layer 320a, and the lower isolation insulating layer 340a of FIG. 4 differs from a shape of each of the lower horizontal insulating layer 140, the upper isolation insulating layer 320, and the lower isolation insulating layer 340 of FIG. 3. As described above, in a process of forming the upper isolation insulating layer 320a and the lower isolation insulating layer 340a, shapes of the upper isolation insulating layer 320a and the lower isolation insulating layer 340a can change due to an etching profile. A method of forming the upper isolation insulating layer 320a and the lower isolation insulating layer 340a will be described in more detail with reference to FIGS. 6 to 17.

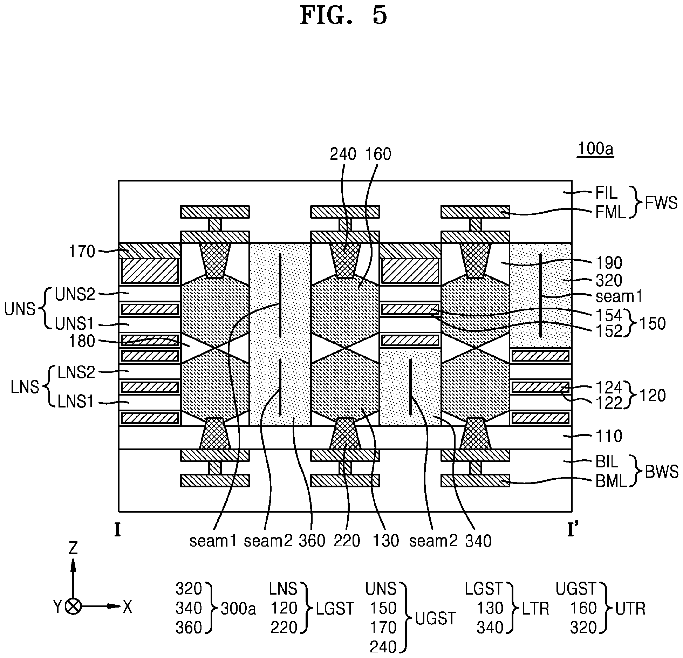

FIG. 5 is a cross-sectional view taken along line I-I' of FIG. 1 according to an embodiment. Description will be made with reference to FIGS. 1 and 5.

Referring to FIG. 5, in an embodiment, a semiconductor device 100a includes a first insulating layer 110, a second insulating layer 180, a third insulating layer 190, an isolation insulating layer structure 300a, a lower transistor LTR, and an upper transistor UTR.

Compared with the semiconductor device 100 of FIG. 2, the semiconductor device 100a of FIG. 5 does not include the lower horizontal insulating layer 140. Therefore, the lower gate structure LGST and the upper gate structure UGST are in contact with each other, the lower gate structure LGST and the upper isolation insulating layer 320 are in contact with each other, the upper gate structure UGST and the lower isolation insulating layer 340 are in contact with each other, and the semiconductor device 100a further includes a through isolation insulating layer 360. The through isolation insulating layer 360 may also be called a through separation insulating layer.

The through isolation insulating layer 360 extends from a vertical level of a top surface of the upper gate structure UGST (e.g., a top surface of the upper source/drain contact 240) to a vertical level of a bottom surface of the lower gate structure LGST. The bottom surface of the through isolation insulating layer 360 is positioned at the same vertical level as the bottom surface of the lower gate structure LGST, and the top surface of the through isolation insulating layer 360 is positioned at the same vertical level as the top surface of the upper gate structure UGST.

The through isolation insulating layer 360 includes a first seam seam1 and a second seam seam2 that are spaced apart from each other in the vertical direction (Z direction). Two etching processes and two deposition processes are performed to form the through isolation insulating layer 360. Therefore, the through isolation insulating layer 360 includes a plurality of seams. At least two of the plurality of seams in the through isolation insulating layer 360 are spaced apart from each other in a vertical direction (Z direction).

FIGS. 6 to 17 are cross-sectional views that illustrate a method of manufacturing a semiconductor device according to an embodiment. FIGS. 6 to 17 are cross-sectional views that illustrate a process sequence of a portion that corresponds to a cross section taken along line I-I' of FIG. 1. Description will be made with reference to FIGS. 1 to 5.

Referring to FIG. 6, in an embodiment, a plurality of sacrificial semiconductor layers 104 and a plurality of nanosheet layers NS are alternately stacked on a substrate 102 one by one. The plurality of nanosheet layers NS include at least one of a group IV semiconductor such as Si or Ge, a group IV-IV compound semiconductor such as SiGe or SiC, and a group III-V compound semiconductor such as GaAs, InAs, or InP. The plurality of sacrificial semiconductor layer 104 include a material that has an etching selectivity with respect to the plurality of nanosheet layer NS. In some embodiments, the plurality of nanosheet layers NS include silicon (Si), and the plurality of sacrificial semiconductor layers 104 include silicon germanium (SiGe). In embodiments, the plurality of nanosheet layers NS and the plurality of sacrificial semiconductor layers 104 are formed by an epitaxial growth process, and the epitaxial growth process may be a chemical vapor deposition (CVD) process such as one of vapor-phase epitaxy (VPE), ultra-high vacuum chemical vapor deposition (UHV-CVD), etc., molecular beam epitaxy, or a combination thereof.

In addition, a preliminary insulating layer 140p is stacked between two sacrificial semiconductor layers 104. The preliminary insulating layer 140p will later physically and/or electrically isolate the gate structure into a lower region, such as a lower gate structure LGST, and an upper region, such as an upper gate structure UGST. The preliminary insulating layer 140p includes at least one of silicon nitride (SiN), silicon oxide (SiO), SiCN, SiBN, SiON, SiOCN, SiBCN, SiOC, and a combination thereof.

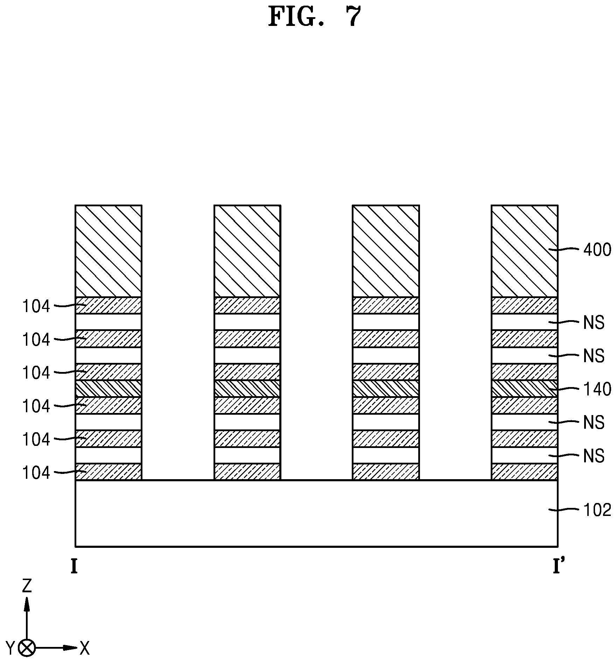

Referring to FIG. 7, in an embodiment, dummy gate lines 400 are formed on an uppermost sacrificial semiconductor layer 104, and at least a portion of each of the nanosheet layer NS, the sacrificial semiconductor layer 104, and the preliminary insulating layer 140p of FIG. 6 are etched by using the dummy gate lines 400 as an etching mask. At least a portion of the preliminary insulating layer 140p of FIG. 6 is removed to form the lower horizontal insulating layer 140. The lower horizontal insulating layer 140 physically and/or electrically isolates the lower region and the upper region of the gate structure GST from each other. The etched portion on the substrate 102 is a portion where the lower source/drain region 130 and the upper source/drain region 160 are formed later.

The dummy gate lines 400 are spaced apart from each other at equal intervals in the first horizontal direction (X direction). In embodiments, the plurality of dummy gate lines 400 include at least one of silicon nitride (SiN), silicon oxide (SiO), polysilicon, and spin-on hardmask. Each of the plurality of dummy gate lines 400 has a double layer structure made of different materials. In addition, dummy gate line spacers may be further formed on sidewalls of the plurality of dummy gate lines 400.

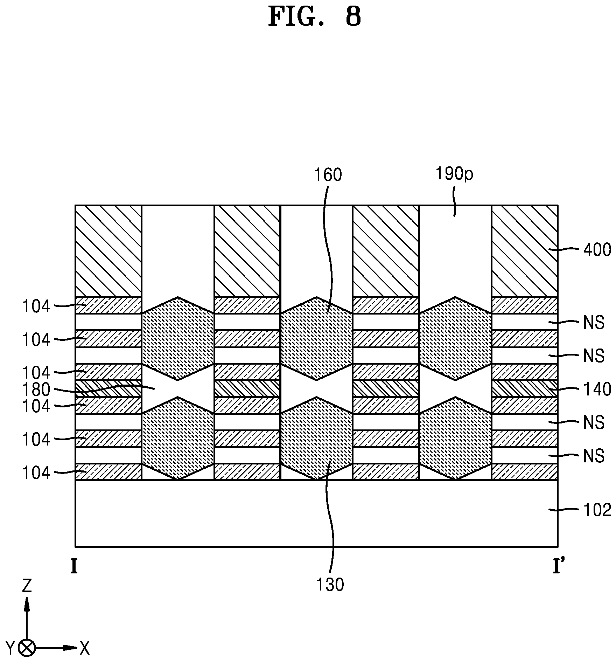

Referring to FIG. 8, in an embodiment, the lower source/drain region 130 and the upper source/drain region 160 are formed in an etched portion of the structure of FIG. 7 through an epitaxial growth method. In addition, a second insulating layer 180 is formed between the lower source/drain region 130 and the upper source/drain region 160, and a preliminary third insulating layer 190p is formed on the upper source/drain region 160. The second insulating layer 180 and the preliminary third insulating layer 190p each include at least one of silicon nitride (SiN), silicon oxide (SiO), SiCN, SiBN, SiON, SiOCN, SiBCN, SiOC, and a combination thereof.

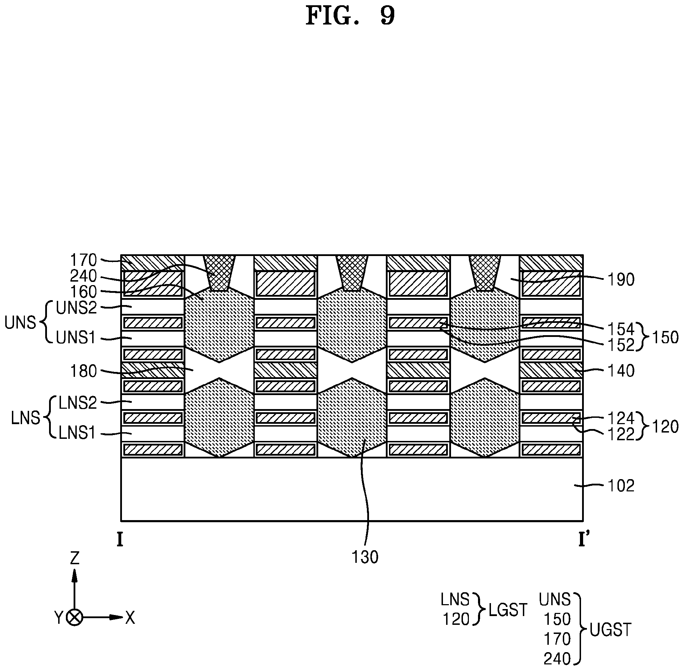

Referring to FIG. 9, the dummy gate lines 400 of FIG. 8 are removed, and at least a portion of the preliminary third insulating layer 190p of FIG. 8 is removed to form a third insulating layer 190. Thereafter, the sacrificial semiconductor layer 104 of FIG. 8 is removed, and a gate is formed. The sacrificial semiconductor layer 104 of FIG. 8 can be removed by a wet etching process based on an etching selectivity.

The gate formed in the lower region may be referred to as a lower gate 120, and the gate formed in the upper region may be referred to as an upper gate 150. The lower gate 120 includes a lower gate electrode 124 and a lower gate dielectric layer 122 that surrounds the lower gate electrode 124. In addition, the upper gate 150 includes an upper gate electrode 154 and an upper gate dielectric layer 152 that surrounds the upper gate electrode 154.

In addition, an upper horizontal insulating layer 170 that extends in the second horizontal direction (Y direction) is formed on the uppermost upper gate 150. The upper horizontal insulating layer 170 physically and/or electrically isolates the uppermost upper gate electrode 154 from different configurations of the semiconductor device 100. The upper horizontal insulating layer 170 includes at least one of silicon nitride (SiN), silicon oxide (SiO), SiCN, SiBN, SiON, SiOCN, SiBCN, SiOC, and a combination thereof.

Through such a process, the lower gate structure LGST and the upper gate structure UGST are formed. The lower gate structure LGST includes a lower nanosheet structure LNS and a lower gate 120, and the upper gate structure UGST may include an upper nanosheet structure UNS, an upper gate 150, and the upper horizontal insulating layer 170. In addition, a lower horizontal insulating layer 140 is interposed between the lower gate structure LGST and the upper gate structure UGST. The upper horizontal insulating layer 170 includes at least one of silicon nitride (SiN), silicon oxide (SiO), SiCN, SiBN, SiON, SiOCN, SiBCN, SiOC, and a combination thereof.

Then, an upper source/drain contact 240 that penetrates the third insulating layer 190 and at least a portion of the upper source/drain region 160 is formed. After forming a trench that penetrates the third insulating layer 190 and at least a portion of the upper source/drain region 160, the trench is filled with a metal and/or a metal nitride to form the upper source/drain contact 240. For example, the upper source/drain contact 240 includes at least one of W, Cu, Al, Ti, Ta, TiN, TaN, an alloy thereof, and a combination thereof.

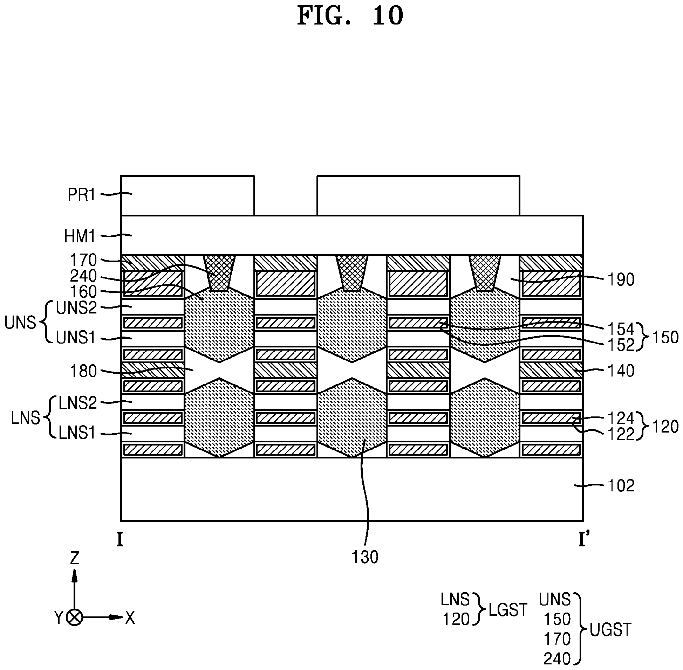

Referring to FIG. 10, in an embodiment, a first hardmask layer HM1 and a first photoresist pattern PR1 are formed on the upper gate structure UGST, the third insulating layer 190, and the upper source/drain contact 240. An opening of the first photoresist pattern PR1 is aligned in a vertical direction (Z direction) with a portion where an upper isolation insulating layer 320 is to be formed later. The first hardmask layer HM1 includes at least one of an amorphous carbon layer (ACL), a silicon oxide layer, and a silicon nitride layer.

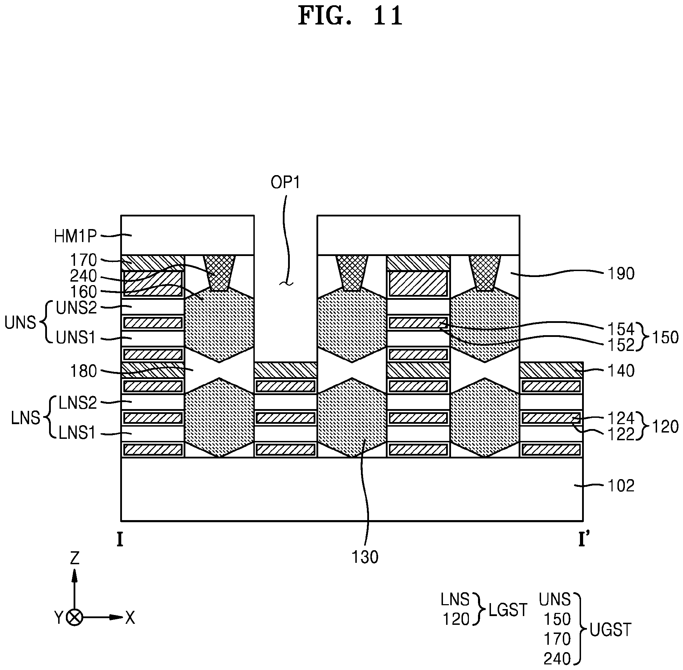

Referring to FIG. 11, in an embodiment, a first hardmask pattern HM1P is formed by etching the first hardmask layer HM1 of FIG. 10 using the first photoresist pattern PR1 of FIG. 10. The first photoresist pattern PR1 of FIG. 10 is removed, and at least a portion of the upper gate structure UGST is etched using the first hardmask pattern HM1P as an etching mask to form a plurality of first openings OP1. Each of the first openings OP1 are formed in a region where the upper isolation insulating layer 320 is to be formed later. The lower horizontal insulating layer 140 functions as an etch stop layer. In other embodiments, at least a portion of the upper gate structure UGST is etched based on an etching process time.

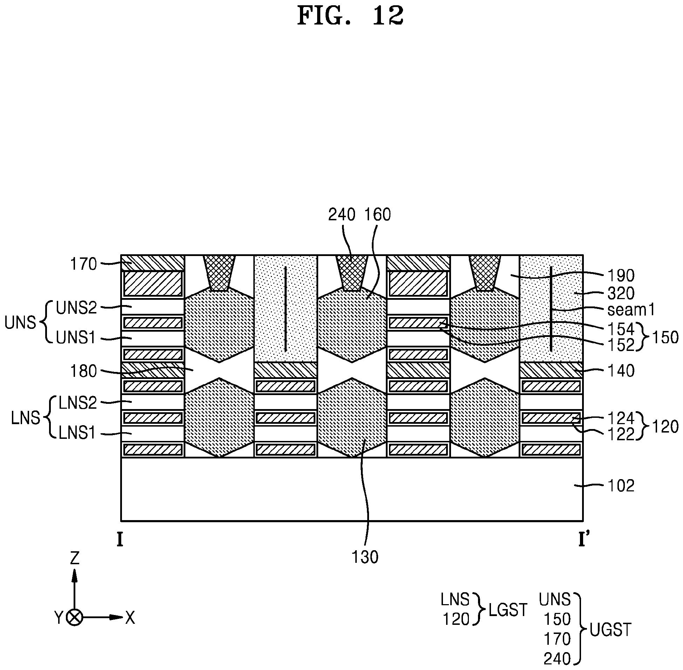

Referring to FIG. 12, in an embodiment, after the first hard mask pattern HMIP of FIG. 11 is removed, an insulating material is formed in the plurality of first openings OP1 of FIG. 11, and at least a portion of the insulating material is chemically mechanically polished (CMP) to form a plurality of upper isolation insulating layers 320. Each of the plurality of upper isolation insulating layers 320 includes a first seam seam1 therein. The first seam seam1 is spaced apart from the lower horizontal insulating layer 140 in the vertical direction Z. The top surface of the upper isolation insulating layer 320 is located at the same vertical level as the top surface of the upper gate structure UGST. The upper isolation insulating layer 320 includes at least one of silicon nitride (SiN), silicon oxide (SiO), SiCN, SiBN, SiON, SiOCN, SiBCN, SiOC, and a combination thereof.

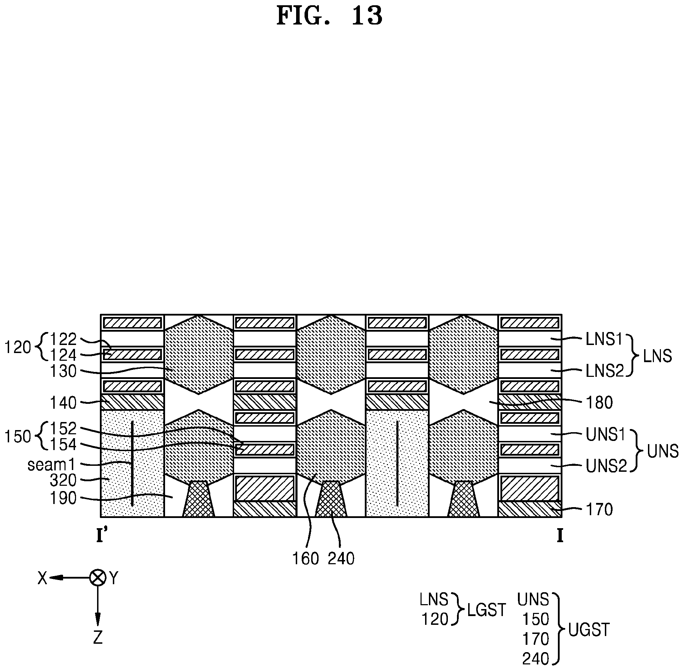

Referring to FIG. 13, in an embodiment, the substrate 102 is removed after inverting the resultant product of FIG. 12.

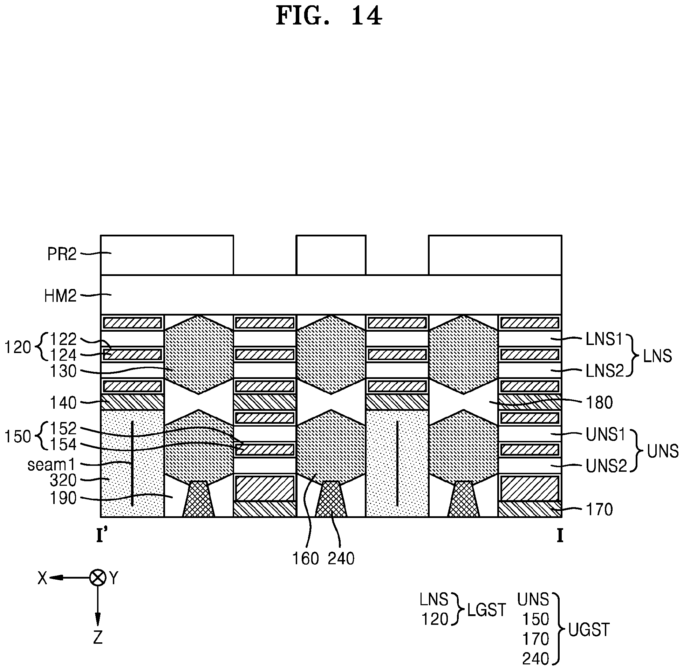

Referring to FIG. 14, in an embodiment, a second hardmask layer HM2 and a second photoresist pattern PR2 are formed on the resultant product of FIG. 13. An opening of the second photoresist pattern PR2 is aligned in a vertical direction (Z direction) with a portion where a lower isolation insulating layer 340 is to be formed later. The second hardmask layer HM2 includes at least one of an amorphous carbon layer (ACL), a silicon oxide layer, and a silicon nitride layer.

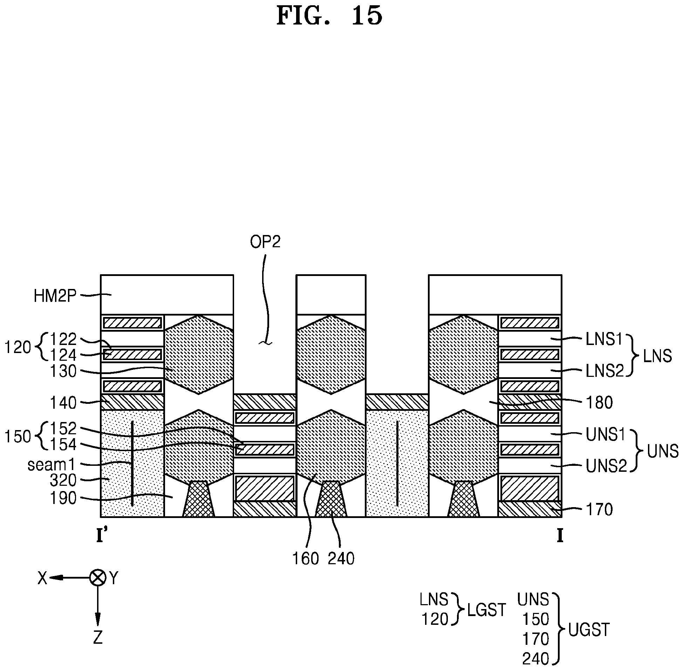

Referring to FIG. 15, in an embodiment, a second hardmask pattern HM2P is formed by etching the second hardmask layer HM2 of FIG. 14 using the second photoresist pattern PR2 of FIG. 14. The second photoresist pattern PR2 of FIG. 14 is removed, and at least a portion of the lower gate structure LGST is etched using the second hardmask pattern HM2P as an etching mask to form a plurality of second openings OP2. Each of the second openings OP2 is formed in a region where the lower isolation insulating layer 340 is to be formed later. The lower horizontal insulating layer 140 functions as an etch stop layer. In other embodiments, at least a portion of the lower gate structure LGST is etched based on an etching process time.

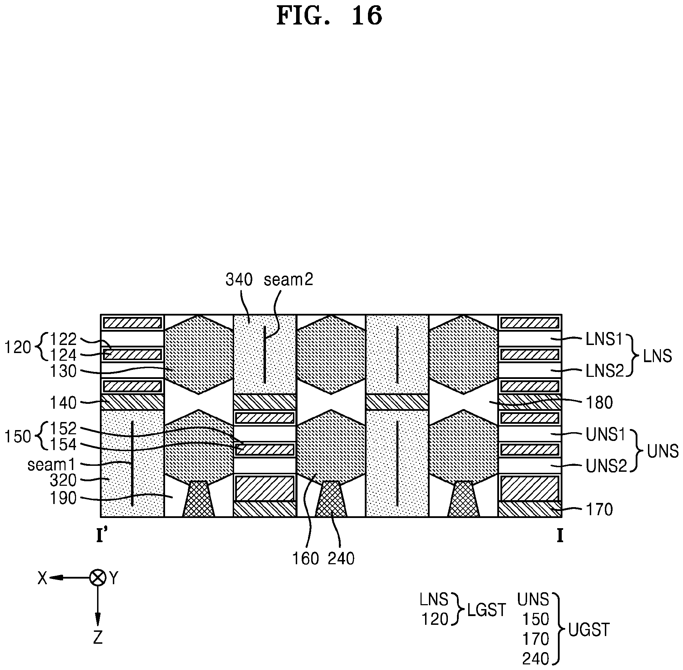

Referring to Fig. 16, in an embodiment, after the second hard mask pattern HM2P of FIG. 15 is removed, an insulating material is formed in the plurality of second openings OP2 of FIG. 15, and at least a portion of the insulating material is chemically and mechanically polished to form a plurality of lower isolation insulating layers 340. Each of the plurality of lower isolation insulating layers 340 includes a second seam seam2 therein. The second seam seam2 is spaced apart from the lower horizontal insulating layer 140 in the vertical direction Z. The bottom surface (the top surface in FIG. 16) of the lower isolation insulating layer 340 is located at the same vertical level as the bottom surface (the top surface in FIG. 16) of the lower gate structure LGST. The lower isolation insulating layer 340 includes at least one of silicon nitride (SiN), silicon oxide (SiO), SiCN, SiBN, SiON, SiOCN, SiBCN, SiOC, and a combination thereof.

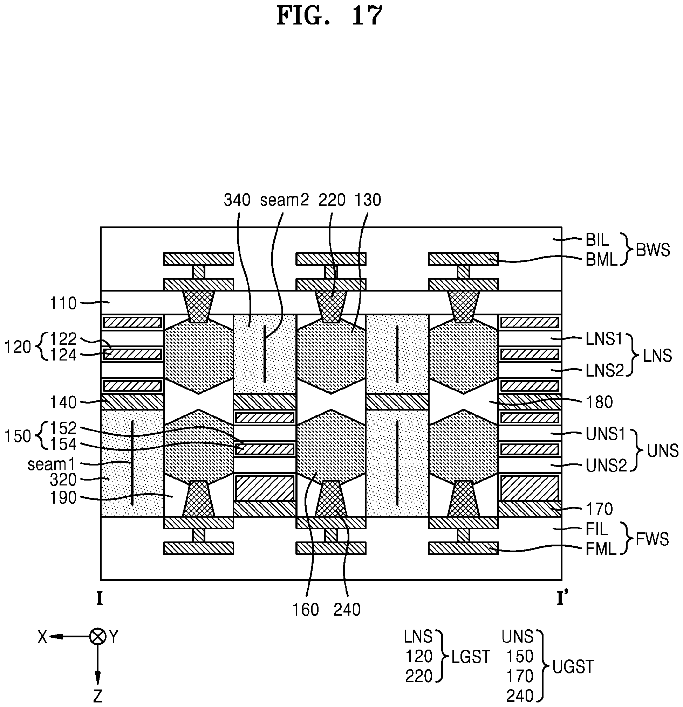

Referring to FIG. 17, in an embodiment, a first insulating layer 110 is formed on the lower gate structure LGST and the lower source/drain region 130, and lower source/drain contacts 220 are formed on the lower source/drain region 130. The lower source/drain contact 220 penetrates the first insulating layer 110 and at least a portion of the lower source/drain region 130. After forming a trench that penetrates the first insulating layer 110 and at least a portion of the lower source/drain region 130, the lower source/drain contact 220 is formed by filling the trench with a metal and/or a metal nitride. For example, the lower source/drain contact 220 includes at least one of W, Cu, Al, Ti, Ta, TiN, TaN, an alloy thereof, and a combination thereof.

Thereafter, a back wiring structure BWS is formed on the lower source/drain contact 220, and a front wiring structure FWS is formed on the upper source/drain contact 240. The back wiring structure BWS includes a first wiring line BML and a first cover insulating layer BIL. The front wiring structure FWS includes a second wiring line FML and a second cover insulating layer FIL. The first and second wiring lines BML and FML each include a plurality of conductive patterns located at different vertical levels and a plurality of conductive vias that connect the plurality of conductive patterns with each other, and the first and second cover insulating layers BIL and FIL each include a plurality of insulating layers that surround the plurality of conductive patterns and the plurality of conductive vias.

As described above, a method according to an embodiment of manufacturing the semiconductor device 100 of FIG 2 has been described with reference to FIGS. 6 to 17. To form the semiconductor device 100a of FIG. 5, in a process of forming the nanosheet layer NS and the sacrificial semiconductor layer 104 of FIG. 6, the preliminary insulating layer 140p is omitted. In addition, at least a portion of the upper isolation insulating layer 320 already generated in the process of forming the second opening OP2 is removed. Thereafter, since the lower isolation insulating layer 340 is formed inside the second opening OP2, the through isolation insulating layer 360 can be integrally formed.

A method of manufacturing the semiconductor device 100 according to an embodiment of the inventive concept includes a method of forming an isolation insulating layer structure 300 at the same vertical level as the lower surface of the lower gate structure LGST. Therefore, the etch depth for forming the isolation insulating layer structure 300 decreases, thereby increasing the reliability of a process of forming the isolation insulating layer structure 300. In addition, since the upper isolation insulating layer 320 and the lower isolation insulating layer 340 are formed at different vertical levels, an arrangement of transistors in the semiconductor device 100 can be diversified.

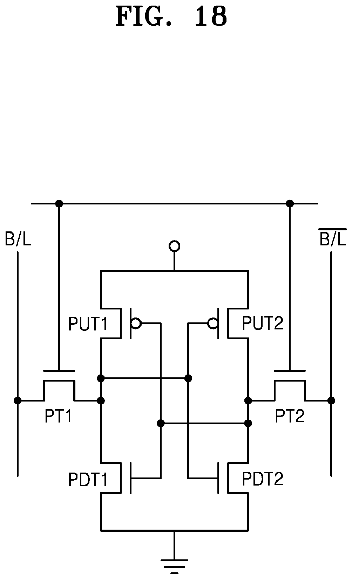

FIG. 18 is a circuit diagram of a semiconductor device according to an embodiment.

Referring to FIG. 18, in an embodiment, a semiconductor device 100 includes six transistors. For example, the semiconductor device 100 includes a first pass transistor PT1, a second pass transistor PT2, a first pull-up transistor PUT1, a second pull-up transistor PUT2, a first pull-down transistor PDT1, and a second pull-down transistor PDT2. The gate of the second pull-up transistor PUT2 and the gate of the second pull-down transistor PDT2 and a bit line B/L are connected to the source/drain region of the first pass transistor PT1. In addition, the gate of the first pull-up transistor PUT1 and the gate of the first pull-down transistor PDT1 and a bit line bar *̅B̅*̅/̅*̅L̅*̅ are connected to the source/drain region of the second pass transistor PT2.

In addition, each of the first pass transistor PT1, the second pass transistor PT2, the first pull-down transistor PDT1, and the second pull-down transistor PDT2 includes an NMOS FET, and each of the first pull-up transistor PUT1 and the second pull-up transistor PUT2 includes a PMOS FET. In addition, the first pull-up transistor PUT 1 and the first pull-down transistor PDT1 constitute a complementary FET (cFET), and the second pull-up transistor PUT2 and the second pull-down transistor PDT2 constitute a complementary FET (cFET). In addition, the first pull-up transistor PUT1 and the first pull-down transistor PDT1 and the second pull-up transistor PUT2 and the second pull-down transistor PDT2 constitute a storage element of the semiconductor device 100.

In the semiconductor device 100 according to an embodiment, the first pull-up transistor PUT1, the first pull-down transistor PDT1, the second pull-up transistor PUT2, and the second pull-down transistor PDT2 include a field effect transistor FET that has a three-dimensional stack (3DS) structure. In addition, the field effect transistor (FET) that has a 3DS structure includes a stacked nanosheet structure.

Embodiments are set out in the following Clauses:
Clause 1. A semiconductor device, comprising:
   a lower transistor; and
   an upper transistor located at a higher vertical level than the lower transistor, wherein
   the lower transistor comprises
      a lower source/drain region, and
      a lower gate structure and a lower isolation insulating layer that are in contact with a side surface of the lower source/drain region, and
   the upper transistor comprises
      an upper source/drain region, and
      an upper gate structure and an upper isolation insulating layer that are in contact with a side surface of the upper source/drain region, wherein
   a bottom surface of the lower isolation insulating layer is positioned at a same vertical level as a bottom surface of the lower gate structure.
Clause 2. The semiconductor device of Clause 1, wherein
   the lower gate structure includes lower gates and nanosheets that are alternately stacked, and
   the upper gate structure includes upper gates and nanosheets that are alternately stacked.
Clause 3. The semiconductor device of Clause 1 or Clause 2, wherein the lower gate structure and the upper gate structure are spaced apart from each other in a vertical direction.
Clause 4. The semiconductor device of any preceding Clause, wherein
   the lower isolation insulating layer extends from an upper surface of the lower gate structure to a lower surface of the lower gate structure, and
   the upper isolation insulating layer extends from an upper surface of the upper gate structure to a lower surface of the upper gate structure.
Clause 5. The semiconductor device of any preceding Clause, wherein
   the upper isolation insulating layer includes a first seam therein, and
   the lower isolation insulating layer includes a second seam therein.
Clause 6. A semiconductor device, comprising:
   a lower transistor; and
   an upper transistor located at a higher vertical level than the lower transistor, wherein the lower transistor comprises
      a lower source/drain region,
      a lower gate structure and a lower isolation insulating layer that are in contact with a side surface of the lower source/drain region, wherein lower gates and lower nanosheets are alternately stacked on the lower gate structure and the lower isolation insulating layer, and
      a lower source/drain contact that is in contact with the lower source/drain region,
   wherein the upper transistor comprises
      an upper source/drain region,
      an upper gate structure and an upper isolation insulating layer that are in contact with a side surface of the upper source/drain region, wherein upper gates and upper nanosheets are alternately stacked on the upper gate structure and the upper isolation insulating layer, and
      an upper source/drain contact that is in contact with the upper source/drain region, wherein a bottom surface of the lower isolation insulating layer is located at a same vertical level as a bottom surface of the lower gate structure.
Clause 7. The semiconductor device of Clause 6, further comprising a lower horizontal insulating layer disposed between the lower gate structure and the upper gate structure and that extends in a horizontal direction.
Clause 8. The semiconductor device of Clause 7, wherein
   a top surface of the lower isolation insulating layer is in contact with the lower horizontal insulating layer, and
   a bottom surface of the upper isolation insulating layer is in contact with the lower horizontal insulating layer.
Clause 9. The semiconductor device of Clause 7 or Clause 8, wherein
   the upper isolation insulating layer includes a first seam therein,
   the lower isolation insulating layer includes a second seam therein, and
   each of the first seam and the second seam is spaced apart from the lower horizontal insulating layer in a vertical direction perpendicular to the horizontal direction.
Clause 10. The semiconductor device of Clause 6, further comprising
   a through isolation insulating layer that extends from a top surface of the upper source/drain contact to a bottom surface of the lower gate structure, wherein
   a bottom surface of the through isolation insulating layer is located at the same vertical level as the bottom surface of the lower gate structure.
Clause 11. The semiconductor device of claim 10, wherein
   the through isolation insulating layer includes a plurality of seams therein, and
   at least two of the plurality of seams are spaced apart from each other in a vertical direction.
Clause 12. A semiconductor device, comprising:
   a lower transistor; and
   an upper transistor located at a higher vertical level than the lower transistor,
   wherein the lower transistor comprises
      a lower source/drain region, and
      a lower gate, a lower nanosheet, and a lower isolation insulating layer that are in contact with a side surface of the lower source/drain region, and
   the upper transistor comprises
      an upper source/drain region,
      an upper gate, an upper nanosheet, and an upper isolation insulating layer that are in contact with a side surface of the upper source/drain region, and
      an upper horizontal insulating layer disposed on the upper gate and at an uppermost end and that extends in one horizontal direction, wherein
      the lower gate and the lower nanosheet are stacked,
      the upper gate and the upper nanosheet are stacked,
      each of the lower gate and the lower nanosheet is spaced apart from the lower isolation insulating layer in a horizontal direction,
      each of the upper gate and the upper nanosheet is spaced apart from the upper isolation insulating layer in the horizontal direction, and
      a bottom surface of the lower isolation insulating layer is located at a same vertical level as a bottom surface of the lower gate at a lowermost end.
Clause 13. The semiconductor device of Clause 12, wherein the lower isolation insulating layer and the upper isolation insulating layer are spaced apart from each other in a vertical direction perpendicular to the horizontal direction.
Clause 14. The semiconductor device of Clause 12 or Clause 13, further comprising
   a lower horizontal insulating layer disposed between the lower isolation insulating layer and the upper isolation insulating layer and that extends in one horizontal direction, wherein
   the lower horizontal insulating layer is in contact with at least one of the lower gate and the lower nanosheet, and is in contact with at least one of the upper gate and the upper nanosheet.
Clause 15. The semiconductor device of Clause 12 or Clause 13, further comprising
   a through separation insulating layer that extends from an uppermost upper gate to a lowermost lower gate, wherein
   the through separation insulating layer includes a plurality of seams therein, and
   at least two of the plurality of seams are spaced apart from each other in a vertical direction perpendicular to the horizontal direction.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device, comprising:
a lower transistor; and
an upper transistor located at a higher vertical level than the lower transistor, wherein
the lower transistor comprises
a lower source/drain region, and
a lower gate structure and a lower isolation insulating layer that are in contact with a side surface of the lower source/drain region, and
the upper transistor comprises
an upper source/drain region, and
an upper gate structure and an upper isolation insulating layer that are in contact with a side surface of the upper source/drain region, wherein
a bottom surface of the lower isolation insulating layer is positioned at a same vertical level as a bottom surface of the lower gate structure.

2. The semiconductor device of claim 1, wherein
the lower gate structure includes lower gates and nanosheets that are alternately stacked, and
the upper gate structure includes upper gates and nanosheets that are alternately stacked.

3. The semiconductor device of claim 1 or claim 2, wherein the lower gate structure and the upper gate structure are spaced apart from each other in a vertical direction.

4. The semiconductor device of any preceding claim, wherein
the lower isolation insulating layer extends from a level of an upper surface of the lower gate structure to a level of a lower surface of the lower gate structure, and
the upper isolation insulating layer extends from a level of an upper surface of the upper gate structure to a level of a lower surface of the upper gate structure.

5. The semiconductor device of any preceding claim, wherein
the upper isolation insulating layer includes a first seam therein, and
the lower isolation insulating layer includes a second seam therein.

6. A semiconductor device, comprising:
a lower transistor; and
an upper transistor located at a higher vertical level than the lower transistor, wherein the lower transistor comprises
a lower source/drain region,
a lower gate structure and a lower isolation insulating layer that are in contact with a side surface of the lower source/drain region, wherein the lower gate structure comprises lower gates and lower nanosheets, and
a lower source/drain contact that is in contact with the lower source/drain region, wherein the upper transistor comprises
an upper source/drain region,
an upper gate structure and an upper isolation insulating layer that are in contact with a side surface of the upper source/drain region, wherein the upper gate structure comprises upper gates and upper nanosheets that are alternately stacked on the lower gate structure and the lower isolation insulating layer, and
an upper source/drain contact that is in contact with the upper source/drain region, wherein a bottom surface of the lower isolation insulating layer is located at a same vertical level as a bottom surface of the lower gate structure,
wherein the lower gates and the lower nanosheets are alternately stacked below the upper gate structure and the upper isolation insulating layer.

7. The semiconductor device of claim 6, further comprising a lower horizontal insulating layer disposed between the lower gate structure and the upper gate structure and that extends in a horizontal direction.

8. The semiconductor device of claim 7, wherein
a top surface of the lower isolation insulating layer is in contact with the lower horizontal insulating layer, and
a bottom surface of the upper isolation insulating layer is in contact with the lower horizontal insulating layer.

9. The semiconductor device of claim 7 or claim 8, wherein
the upper isolation insulating layer includes a first seam therein,
the lower isolation insulating layer includes a second seam therein, and
each of the first seam and the second seam is spaced apart from the lower horizontal insulating layer in a vertical direction perpendicular to the horizontal direction.

10. The semiconductor device of claim 6, further comprising
a through isolation insulating layer that extends from a top surface of the upper source/drain contact to a bottom surface of the lower gate structure, wherein
a bottom surface of the through isolation insulating layer is located at the same vertical level as the bottom surface of the lower gate structure.

11. The semiconductor device of claim 10, wherein
the through isolation insulating layer includes a plurality of seams therein, and
at least two of the plurality of seams are spaced apart from each other in a vertical direction.

12. A semiconductor device, comprising:
a lower transistor; and
an upper transistor located at a higher vertical level than the lower transistor,
wherein the lower transistor comprises
a lower source/drain region, and
a lower gate, a lower nanosheet, and a lower isolation insulating layer that are in contact with a side surface of the lower source/drain region, and
wherein the upper transistor comprises
an upper source/drain region,
an upper gate, an upper nanosheet, and an upper isolation insulating layer that are in contact with a side surface of the upper source/drain region, and
an upper horizontal insulating layer disposed on the upper gate and at an uppermost end and that extends in one horizontal direction, wherein
the lower gate and the lower nanosheet are stacked,
the upper gate and the upper nanosheet are stacked,
each of the lower gate and the lower nanosheet is spaced apart from the lower isolation insulating layer in a horizontal direction,
each of the upper gate and the upper nanosheet is spaced apart from the upper isolation insulating layer in the horizontal direction, and
a bottom surface of the lower isolation insulating layer is located at a same vertical level as a bottom surface of the lower gate at a lowermost end.

13. The semiconductor device of claim 12, wherein the lower isolation insulating layer and the upper isolation insulating layer are spaced apart from each other in a vertical direction perpendicular to the horizontal direction.

14. The semiconductor device of claim 12 or claim 13, further comprising
a lower horizontal insulating layer disposed between the lower isolation insulating layer and the upper isolation insulating layer and that extends in one horizontal direction, wherein
the lower horizontal insulating layer is in contact with at least one of the lower gate and the lower nanosheet, and is in contact with at least one of the upper gate and the upper nanosheet.

15. The semiconductor device of claim 12 or claim 13, further comprising
a through separation insulating layer that extends from a level of an uppermost upper gate to a level of a lowermost lower gate, wherein
the through separation insulating layer includes a plurality of seams therein, and
at least two of the plurality of seams are spaced apart from each other in a vertical direction perpendicular to the horizontal direction.
